(19) **Europäisches Patentamt**
**European Patent Office**
**Office européen des brevets**

(11) **EP 4 787 431 A1**

(12) **EUROPEAN PATENT APPLICATION**

(43) Date of publication:
**05.08.2026  Bulletin 2026/32**

(21) Application number: **25155596.7**

(22) Date of filing: **03.02.2025**

(51) International Patent Classification (IPC):
**H01L 21/67** (2006.01)     **H01L 21/687** (2006.01)
**H01L 21/683** (2006.01)

(52) Cooperative Patent Classification (CPC):
**H10P 72/0428; H10P 72/7614;** H10P 72/72;
H10P 72/78

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **VON MORZE, Natascha**
  **5500 AH Veldhoven (NL)**

• **BURGARTH, Volker**
  **5500 AH Veldhoven (NL)**
• **BLUMBERG, Christian**
  **5500 AH Veldhoven (NL)**
• **KIEVEN, David**
  **5500 AH Veldhoven (NL)**
• **WARMING, Till**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR BONDING SEMICONDUCTOR SUBSTRATES**

(57)    The present disclosure relates to a method of bonding a first semiconductor substrate and a second semiconductor substrate. The method may comprise clamping the first semiconductor substrate to a clamp such that the first semiconductor substrate is supported by a plurality of support protrusions on the clamp. The method may further comprise, applying a force to the first semiconductor substrate to initiate the bonding of the first semiconductor substrate and the second semiconductor substrate. The force may be generated by, or transmitted by, the plurality of support protrusions on the clamp. The applying of the force to the first semiconductor substrate to initiate the bonding of the first semiconductor substrate and the second semiconductor substrate may simultaneously initiate a plurality of bond fronts.

## Fig. 5

**Description**

FIELD OF INVENTION

The present invention relates to methods and apparatuses for bonding semiconductor substrates.

BACKGROUND

In the manufacture of integrated circuits (ICs), circuit features are formed on/in semiconductor substrates. To form circuit features on/in a semiconductor substrate, various processes may be performed such as: depositing a layer of photoresist on a surface on the semiconductor substrate; imparting of a pattern to the layer of photoresist using lithography; etching material away from the semiconductor substrate or layers deposited thereon, in accordance with the pattern imparted to the layer of photoresist during lithography; and modifying characteristics of the semiconductor substrate or the layers formed thereon, (e.g. through oxidation, doping, ion implantation, etc.).

To form some types of device, one semiconductor substrate (which may have circuit features formed thereon) may be bonded with another semiconductor substrate (which may also have circuit features formed therein/thereon). Bonding processes include die-to-die, die-to-wafer and wafer-to-wafer bonding processes. Wafer-to-wafer bonding involves whole wafers being permanently bonded together prior to dicing. In die-to-die bonding, an individual die (which may originate from a wafer that has been diced) may be bonded to another individual die (which may also originate from a wafer that has been diced. In die-to-wafer bonding, an individual die (which may originate from a wafer that has been diced) may be bonded to a whole wafer. In bonding process, a high accuracy and a high throughput are important.

The surfaces of the semiconductor substrate which are bonded together may comprise a plurality of metallic portions. The metallic portions may be configured such that, once the two substrates are bonded together, the two semiconductor substrates are in electrical contact with one another via the metallic portions. Thus, the circuit features of the two semiconductor substrates can operate together.

During typical bonding methods, distortions may be induced in the semiconductor substrates that are being bonded together. For example, distortions may be induced by the propagation of a bond front from a centrally-located bond initiation point to the edge of the substrate. These distortions may have a negative effect on the product that comprises the bonded semiconductor substrates. For example, distortion may result in misalignment of the metallic portions, which may mean that the product does not function as intended. This may mean that throughput is reduced, because a significant number of products are scrapped.

SUMMARY OF THE INVENTION

An aim of the invention is to provide a method of bonding two substrates which causes less distortion to the substrates.

An aspect of the present disclosure is a method of bonding a first semiconductor substrate and a second semiconductor substrate. The method may comprise clamping the first semiconductor substrate to a clamp such that the first semiconductor substrate is supported by a plurality of support protrusions on the clamp. The method may further comprise applying a force to the first semiconductor substrate to initiate the bonding of the first semiconductor substrate and the second semiconductor substrate. The force may be generated by, or transmitted by, the plurality of support protrusions on the clamp. The applying of the force to the first semiconductor substrate to initiate the bonding of the first semiconductor substrate and the second semiconductor substrate may simultaneously initiate a plurality of bond fronts.

Another aspect of the present disclosure is a clamp, which is configured to clamp a first semiconductor substrate in a method of bonding the first semiconductor substrate to a second semiconductor substrate. The clamp may comprise a plurality of support protrusions. The plurality of support protrusions may be configured to support the first semiconductor substrate when the first semiconductor substrate is clamped to the clamp. The plurality of support protrusions may be configured to generate or transmit a force to the first semiconductor substrate to initiate the bonding of the first semiconductor substrate and the second semiconductor substrate. The force may simultaneously initiate a plurality of bond fronts.

Another aspect of the present disclosure is a clamping system for bonding a first semiconductor substrate and a second semiconductor substrate. The clamping system may comprise a first clamp, wherein the first clamp is the clamp described above. The clamping system may further comprise a second clamp configured to clamp the second semiconductor substrate.

Initiating the bonding between the first semiconductor substrate and the second semiconductor substrate by applying the force to the first semiconductor substrate using the support protrusions (e.g. by the support protrusions generating the force or by the support protrusions transmitting the force) may result in a plurality of bond initiation points. Consequently, a plurality of bond fronts may be initiated simultaneously. A bonding method in which a plurality of relatively small bond fronts are initiated results in less distortion than a bonding method in which one (or a few) large bond front(s) are initiated. Consequently, the bonding method of the present disclosure reduces distortion of the semiconductor substrates during bonding, and therefore improves product quality and yield. Initiating a plurality of relatively small bond fronts may also allow the duration of bond front propagation to be decreased, thus increasing throughput (especially in wafer-to-wafer bonding).

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

## BRIEF DESCRIPTION OF THE DRAWINGS

Embodiments of the invention will now be described, by way of example, with reference to the accompanying drawings which are briefly described below.

Figure 1 depicts a lithographic apparatus together with other apparatuses forming a production facility for semiconductor devices.

Figure 2 is a diagram describing a present method of manufacturing integrated devices which utilizes the bonding of substrates.

Figure 3 schematically depicts a hybrid bonding process.

Figure 4A depicts the steps of a conventional bonding method. Figure 4B depicts the alignment of metallic portions of the two substrates at various stages of the conventional bonding method.

Figure 5 depicts a clamping system in accordance with an embodiment.

Figures 6A and 6B schematically depict a portion of a clamping method, in accordance with an embodiment.

Figure 7 depicts a plot of lateral displacement in a substrate caused by a clamping pressure against a pitch of support protrusions on a clamp.

Figure 8 depicts a plot of the oscillation period of a support protrusion against the spring constant of the support protrusion.

Figure 9 depicts a plot of a required clamping pressure against the spring constant of the support protrusion.

Figures 10A and 10B schematically depict a portion of a clamping method, in accordance with another embodiment.

Figures 11A and 11B schematically depict a portion of a clamping method, in accordance with another embodiment.

## DETAILED DESCRIPTION

Before describing embodiments of the invention in detail, it is instructive to present an example environment in which embodiments of the present invention may be implemented.

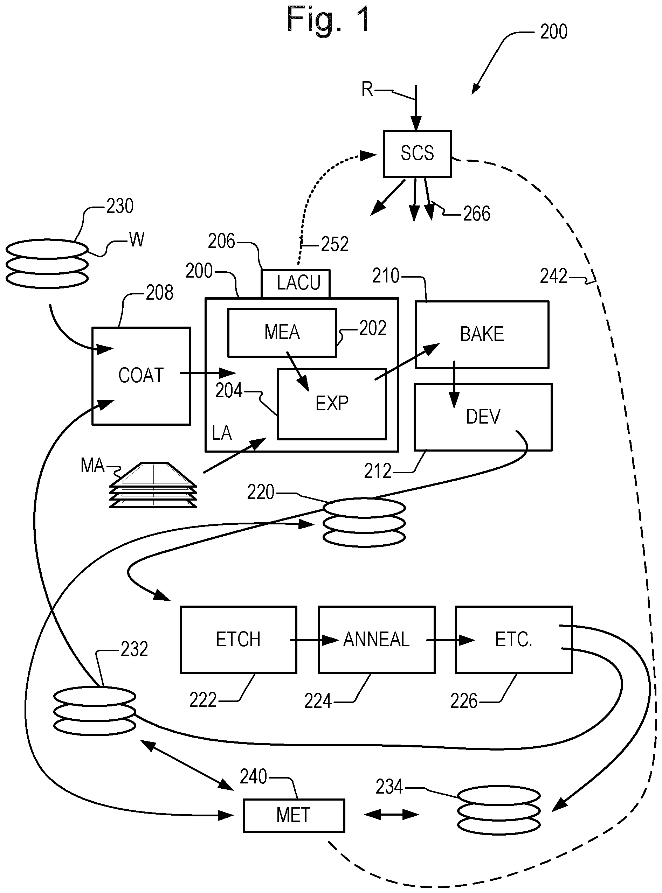

Figure 1 at 200 shows a lithographic apparatus LA as part of an industrial production facility implementing a high-volume, lithographic manufacturing process. In the present example, the manufacturing process is adapted for the manufacture of semiconductor products (integrated circuits) on semiconductor substrates (e.g. semiconductor wafers). The products may form part of an electronic device. The skilled person will appreciate that a wide variety of products can be manufactured by processing different types of substrates in variants of this process. The production of semiconductor products is used purely as an example which has great commercial significance today.

Within the lithographic apparatus (or "litho tool" for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore, some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly, a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

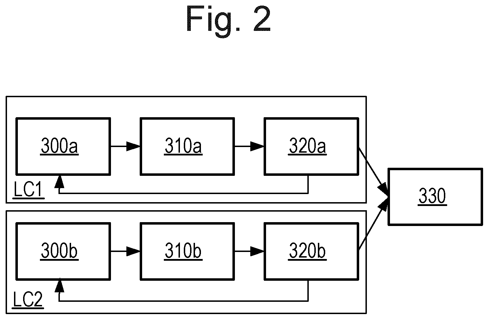

Figure 2 schematically depicts a device manufacturing arrangement/method for making bonded substrates (and therefore ICs based on bonded substrates) comprising a first manufacturing lithocell LC1 and a second manufacturing lithocell LC2. Within each lithocell is a lithographic processing system 300a, 300b and a first metrology system 310a, 310b. The lithographic processing system 300a, 300b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 320a, 320b in communication with its respective lithographic processing system 300a, 300b and metrology system 310a, 310b, so that results, designs, data, etc. of the lithographic processing system 300a, 300b and/or the metrology apparatus 310a, 310b may be stored and analyzed by the software application 320a, 320b at the same time or different times.

Once pairs of substrates (e.g. wafers) are completed from each of lithocell LC1 and lithocell LC2, they may be bonded within a bonding tool 330 to obtain a bonded wafer. A pair of substrates from a single lithocell (e.g. lithocell LC1) may also be bonded together. Bonding in this context may be wafer-to-wafer bonding where whole wafers are aligned and bonded together such that individual dies on each wafer are aligned. The concept of wafer-to-wafer bonding is known and used in many IC manufacturing processes. Bonding in this context may also be wafer-to-die or die-to-wafer bonding, in which an individual die is bonded to a wafer. Bonding in this context may also be die-to-die bonding, in which one individual die is bonded to another individual die. As used herein, the term "bonding method" is used to mean methods of bonding of one semiconductor substrate to another semiconductor substrate. The term "bonding method" is used to cover the bonding of one wafer to another wafer, of one die to a wafer, and of one die to another die. Further, as used herein (unless otherwise specified), the term "substrate" means "semiconductor substrate", which covers both wafers and dies.

The bonding tool 330 may comprise a bonding alignment device for aligning the substrates together for bonding. For example, the bonding tool 330 may perform pre-align using box-in-box marks provided to substrates (e.g., one box on each substrate), with visual inspection of marks used for alignment quality/ position control. Another method uses two imaging sensors (e.g., face to face) which are first calibrated together to find their relative positions; each sensor is then used to separately align a respective substrate to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 300a and 300b may comprise different tools or the same tools within each respective system. Similarly, metrology apparatuses 310 and 310b may be the same apparatus or different apparatuses. The software application 320a, 320b may be comprised within one or both of the respective lithographic processing systems 300a, 300b and/or one or both of the first metrology systems 3 10a, 3 10b, or elsewhere.

Once bonded, the bonded substrate may be subject to further lithographic patterning and processing. As such, alignment will be performed on the bonded substrate; e.g., for aligning the substrate and determining feed-forward corrections based on measured grid deformities. Also, post-exposure metrology, such as overlay metrology, may be performed on the bonded substrate after exposure; e.g., to determine feedback corrections for subsequent substrates.

At present, various bonding techniques have been implemented to bond semiconductor substrates (e.g. wafers). Among existing bonding techniques, fusion bonding and hybrid bonding are widely employed for bonding semiconductor substrates. Fusion bonding enables permanent connection via dielectric layers on each bonding semiconductor substrate and provides a good bonding strength with a high bonding yield. The dielectric layers may comprise, for example, silicon oxide, e.g. activated silicon oxide of the form $SiO_xH_y$. Additionally or alternatively, the dielectric layers may comprise, for example, SiON, e.g. activated SiON of the form $SiO_xN_yH_z$. The activation of the silicon oxide or the SiON may comprise plasma activation or activation comprising use of a hydrogen radical generator or exposure to UV light.

Typically, the fusion bonding process comprises three main steps: 1) surface preparation which may include surface planarization, cleaning and activation; 2) pre-bonding at room temperature which may include aligning the two bonding surfaces; and 3) annealing (or heat treatment) at elevated temperatures (e.g., 200°C to 500°C). In the fusion bonding process, spontaneous adhesion of the two bonding surfaces occurs at room temperature via Van der Waals forces between the two bonding surfaces and via hydrogen bridge bonds of chemisorbed water molecules. The hydrogen bridge bonds of chemisorbed water molecules may react during the annealing step to form covalent siloxane bonds. The spontaneous adhesion of the two bonding surfaces (e.g. through Van der Waals forces and the like) may be referred to as optical bonding. Further information about the fusion bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

Hybrid bonding combines fusion bonding and metal diffusion bonding into a single bonding process and enables formation of dielectric-to-dielectric and metal-to-metal bonds between the bonding surfaces of the two substrates. The metal-to-metal bonds between the two substrates may provide one or both of: (a) increased bond strength between the two substrates; and (b) electrical connection between the two substrates (e.g. electrical connection between a functional device formed on one substrate and another functional device formed on another substrate).

In a hybrid bonding process, metal is embedded in bonding surfaces of the substrates that are to be bonded together. The metal may be copper, gold, or any other metal or metal alloy with a coefficient of thermal expansion that is greater than the coefficient of thermal expansion of the material from which the dielectric layer is formed. The metal may be embedded in the dielectric layer of the substrates that are to be bonded together. The metal embedded in the substrates may be in the form of a plurality of metallic portions (which may be referred to as metallic pads) distributed across the substrates (e.g. distributed across the dielectric layer of the substrates). The metallic portions may be formed in a surface preparation step of the hybrid bonding method. For example, the metallic pads may be formed by etching the dielectric layer on the substrate (e.g., to create vias to the metal below) and electroplating (or electrochemical deposition (ECD) of) at least part of the etched dielectric layer to form metal pads therewithin. The bonding surface of a substrate may also be referred to as a joining surface of the substrate.

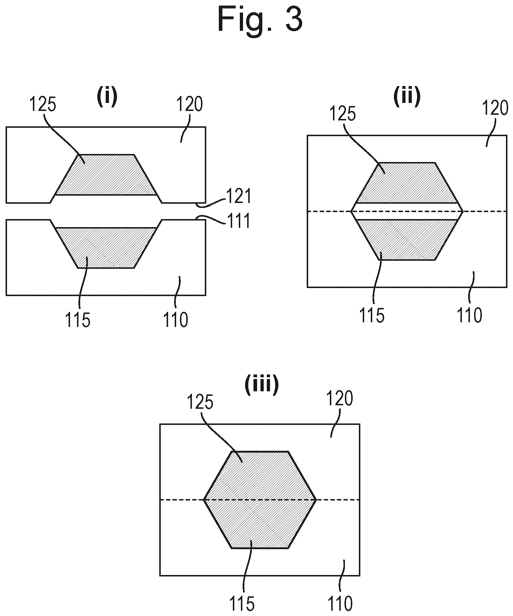

Similarly to the fusion bonding process, the hybrid bonding process also comprises the following three main steps: 1) surface preparation (in which the metallic portions may be formed, as described above); 2) pre-bonding at room temperature; and 3) annealing (or heat treatment) at elevated temperatures. Steps (2) and (3) are schematically depicted in Figure 3, which depicts a metallic portion 115 in a first substrate 110 and a metallic portion 125 in a second substrate 120. The single metallic portion on each of the first and second substrate 110, 120 is shown to explain the hybrid bonding process, and is representative of a plurality of metallic portions 115, 125.

At stage (i) in Figure 3, a bonding surface 111 of the first substrate 110 is separated (e.g. spaced apart from) from a bonding surface 121 of the second substrate 120. The bonding surface 111 of the first substrate 110 may be formed at least partially by a dielectric layer (not shown). The metallic portion 115 may be recessed below the bonding surface 121, but exposed at the bonding surface 121 (e.g. not covered by the dielectric layer). The bonding surface 121 of the second substrate 120 may be formed at least partially by a dielectric layer (not shown). The metallic portion 125 may be recessed below the bonding surface 121, but exposed at the bonding surface 121 (e.g. not covered by the dielectric layer).

In the hybrid bonding process, the two substrates 110, 120 may be aligned with one another. Then, the two substrates 110, 120 may be brought together such that the bonding surfaces 111, 121 come into contact, and are spontaneously bonded together (e.g. by optical bonding). At stage (ii) in Figure 3) the two substrates 110, 120 have been brought into contact with one another. At this point in the process, the metallic portion 115 of the first substrate 110 may not be bonded with (or in contact with) the metallic portion 125 of the second substrate 120. This may be because the metallic portions 115, 125 are recessed below the respective bonding surfaces 111, 121, as described above. By recessing the metallic portions 115, 125 below the respective bonding surfaces 111, 121, the metallic portions 115, 125 do not interfere with the initial optical bonding that occurs between the (dielectric) bonding surfaces 111, 121.

At stage (iii) in Figure 3, the two substrates 110, 120 have been subjected to an annealing (or heat treatment) step. As described above, the annealing (or heat treatment) transfers hydrogen bridge bonds to covalent siloxane bonds. Further, the heating of the metallic portions 115, 125 causes the metallic portions 115, 125 to expand up to or beyond the level of the respective bonding surfaces 111, 121. Thus, the metallic portions 115, 125 come into contact with one another. Where the metallic portions 115, 125 come into contact with one another, metal diffusion bonds may be formed. Further information about the hybrid bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

In many fusion or hybrid bonding applications, intermediate layers (e.g., silicon dioxide (SiO2), silicon carbon nitride (SiCN), silicon oxynitride (SiON)) are used to enhance bonding strength.

The present disclosure focuses primarily on an example involving fusion bonding. However, as will be appreciated, the techniques disclosed herein are equally applicable to fusion bonding.

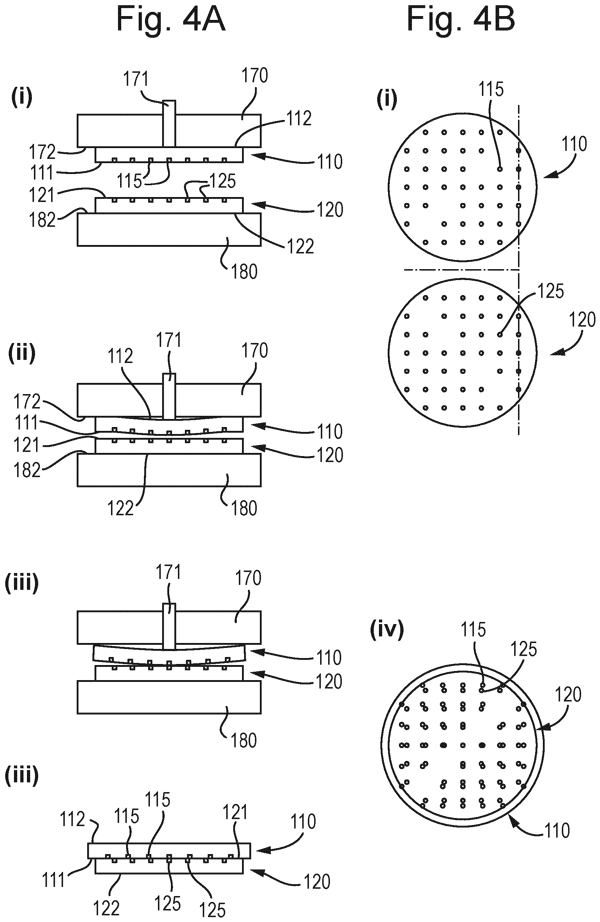

A conventional bonding method will now be described with reference to Figures 4A and 4B. The bonding method depicted in Figure 4A is a method for bonding a first semiconductor substrate 110 and a second semiconductor substrate 120. The first semiconductor substrate 110 comprises a bonding surface 111 and a plurality of metallic portions 115 distributed across the bonding surface 111. The second semiconductor substrate 120 also comprises a bonding surface 121 and a plurality of metallic portions 125 distributed across the bonding surface 121. This has been described in detail above.

In step (i) depicted in Figure 4A the first semiconductor substrate 110 is clamped to a first clamp 170. Specifically, a back surface 112 of the first semiconductor substrate 110 is in contact with a clamping surface 172 of the first clamp 170. As used in the present disclosure, the "back surface" of a substrate is a surface which is opposite to the bonding surface.

The clamping surface 172 of the first clamp 170 may comprise a plurality of support protrusions ("burls", not shown in the Figures). The back surface 112 of the first semiconductor substrate 110 may be supported on distal ends of the plurality of support protrusions. The first clamp 170 may be an electrostatic clamp comprising one or more electrodes (not shown) configured to apply an electrostatic clamping force to the first semiconductor substrate 110 to clamp the first semiconductor substrate 110 to the first clamp 170. Alternatively, the first clamp 170 may be a vacuum clamp. By contacting the back surface 112 of the first semiconductor substrate, the support protrusions may prevent the first semiconductor substrate moving towards the first clamp 170 under the influence of the clamping force exerted by the first clamp 170.

The second semiconductor substrate 120 may be clamped to a second clamp 180 in substantially the same way as the first substrate 110 is clamped to the first clamp 170. The first clamp 170 and the second clamp 180 may be arranged such that the bonding surfaces 111, 121 of the first and second substrates 110, 120 face one another.

As shown in Figure 4B, during step (i) (i.e. before the first substrate 110 is brought into contact with the second substrate 120), the metallic portions 115 on the first substrate 110 may be substantially aligned with the metallic portions 125 portions on the second substrate 120.

The first clamp 170 may comprise a pushing means configured to push the first substrate 110 towards the second substrate 120. As shown in Figure 4A, the pushing means may comprise a pin 171. The pin 171 extends through a body of the first clamp 170. The pin 171 is extensible and retractable, so that the pin 171 can push the first substrate 110 towards the second substrate 120. The pin 171 may be configured to initiate contact between the first substrate 110 and the second substrate 120. Thus, the pin 171 may be configured to initiate spontaneous bonding between the first substrate 110 and the second substrate 120.

The pin 171 is located in a central (e.g. radially central) portion of the first clamp 170, such that the pin 171 pushes against a central (e.g. radially central) portion of the back surface 112 of the first substrate 110. In the example depicted in Figure 4A, the second clamp 180 does not comprise a pushing means.

In steps (ii) and (iii), the first substrate 110 is brought into contact with the second substrate 120. To bring the first substrate into contact which the second substrate 120, the clamping force (e.g. electrostatic clamping force or vacuum clamping force) exerted on the first substrate 110 by the first clamp 170 (e.g. by one or more electrodes in the first clamp 170 or by a pressure difference) is released or reduced. Simultaneously, the pin 171 is extended so as to apply a pushing force to the back surface 112 of the first substrate 110.

As the pin 171 pushes against the central portion of the first substrate 110, the central portion of the first substrate 110 moves towards the second substrate 120. Thus, a central portion of the bonding surface 111 of the first substrate 110 comes into contact with the bonding surface 121 of the second substrate. As the central portion of the bonding surface 111 of the first substrate 110 comes into contact with the bonding surface 121 of the second substrate 120, spontaneous bonding (e.g. by Van der Waal's forces and the like) occurs therebetween. This spontaneous bonding causes the first substrate 110 to be pulled down onto the second substrate 120. This occurs first at the radially-central portion of the first substrate 110, and then propagates radially outwards. The radially outward propagation of the region at which the bonding surface 111 of the first substrate 110 is bonded to the bonding surface 121 of the second substrate 120 is referred to as a bond front (or "bond wave"). The bond wave propagates from the point of bond initiation (which corresponds to the position of the pin 171) to the edges of the first semiconductor substrate 110. As the first substrate 110 is pulled down onto the second substrate 120, air (or other gas) between the two substrates 110, 120 is displaced.

The speed at which the bond front propagates over the first substrate 110 may depend on various factors, such as: surrounding atmosphere pressure, temperature, the surrounding gas type, the surrounding gas density, patterns in the first substrate 110; crystal orientations in the first substrate 110; and pre-existing tensions in the first substrate 110. These factors may not be uniform over the surface of the first substrate 110. Consequently, the propagation of the bond front may not occur uniformly. A non-uniform propagation of the bond front may lead to local tensions in the first substrate 110, which in turn lead to distortions in the first substrate 110. These distortions may have a negative effect on the product that comprises the bonded semiconductor substrates. For example, distortions may mean that the product does not function as intended. It may not be possible to correct the distortions in subsequent steps of the manufacturing process. Consequently, the occurrence of distortion in the first substrate 110 during the bonding method may mean that throughput is reduced, because a significant number of products are scrapped.

Moreover, even if the bond front is substantially uniform, the propagation of the bond front from the central initiation point to the edges of the substrate may lead to an expansion (e.g. a stretch) of the first substrate 110 in the radial direction. Consequently, at step (iv) in Figure 4A-where the first substrate 110 and the second substrate 120 have been bonded together and removed from the first and second clamp 170, 180-the metallic portions 115 of the first substrate may not be aligned with the metallic portions of 125 of the second substrate 120. Specifically, the metallic portions 115 of the first substrate 110 may be displaced radially outwards compared to the metallic portions 125 of the second substrate 120.

Once the first substrate 110 is fully in contact with second substrate 120 (and therefore the first substrate 110 is bonded to the second substrate 120), the first substrate 110 may not be able to contract (i.e. relax) back to its original dimensions. Thus, the first substrate 110 may remain in its radially-expanded form. Thus, the metallic portions of the first substrate 110 may remain misaligned relative to the metallic portions of the second substrate 120. Misalignment of the metallic portions may mean that the product does not function as intended. This may mean that throughput is reduced, because a significant number of products are scrapped. It is noted that the metallic portions may be very small relative to the substrate W, and any (e.g. even partial) misalignment between the metallic portions may lead to a worsening of the performance of the product.

The present disclosure provides methods of bonding the first substrate 110 and the second substrate 120 which result in less distortion of the substrates (e.g. the first substrate 110 and/or the second substrate 120) as they are bonded together. Consequently, various advantages are realized, such as improved functionality and reliability of the products that are formed from the bonded substrates 110, 120, increased throughout (because fewer products are scrapped after being determined to be malfunctioning), etc.

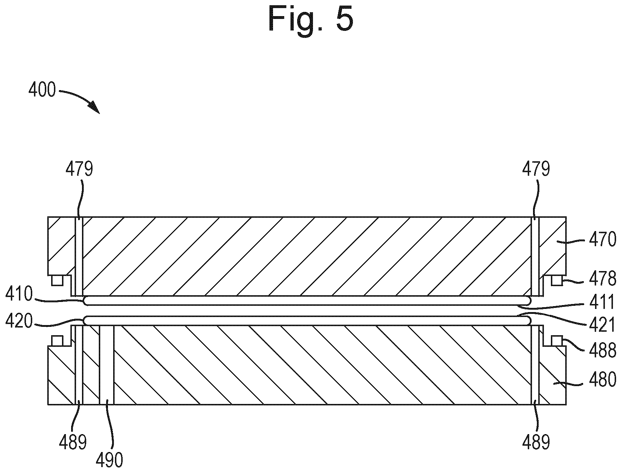

The bonding method of the present disclosure may be performed by a clamping system 400, an example of which is depicted in Figure 5. The clamping system may have similarities with the clamping system depicted in Figure 4A. For example, the clamping system 400 may comprise a first clamp 470 for supporting a first substrate 410 and a second clamp 480 for supporting a second substrate 420. The first clamp 470 may be above the second clamp 480 in a gravitational direction. The first clamp 470 and/or the second clamp 480 may be electrostatic clamps. The first substrate 410 may be a wafer (e.g. a wafer with a diameter of approximately 300 mm) or a die. The second substrate 420 may be a wafer (e.g. a wafer with a diameter of approximately 300 mm) or a die.

There may be several differences between the clamping system 400 of the present disclosure and that depicted in Figure 4A. For example, the clamping system 400 may not comprise a pin (such as the pin 171) for the initiation of the bonding of the first substrate 410 and the second substrate 420. Other differences between the clamping system 400 of the present disclosure and the clamping system depicted in Figure 4A will become apparent from the following description.

The first clamp 470 and/or the second clamp 480 may be moveable in a vertical direction (i.e. a direction perpendicular to the planes in which the first substrate 410 and the second substrate 420 extend). This may be such that the first substrate 410 and the second substrate 420 can be moved towards and away from one another.

In the bonding method of the present disclosure, before initiating bonding between the first substrate 410 and the second substrate 420, a distance between the first substrate 410 and the second substrate 420 may be decreased. That is, the first substrate 410 and the second substrate 420 may be brought closer to one another. This may be achieved by movement of the first clamp 470 towards the second clamp 480 and/or movement of the second clamp 480 towards the first clamp 470.

The decreasing of the distance between the first substrate 410 and the second substrate 420 may be controlled based on measurements made by a distance sensor 478, 488. The distance sensor 478, 488 may comprise a portion 478 mounted on the first clamp 470 and a portion 488 mounted on the second clamp 480.

Before, after, or during the decreasing of the distance between the first substrate 410 and the second substrate 420, the first substrate 410 may be aligned with the second substrate 420. The clamping system 400 may comprise one or more sensors configured for the alignment of the first substrate 410 and the second substrate 420. For example, the first clamp 470 may comprise one or more (e.g. three or more) sensors 479 (e.g. optical sensors) configured to determine a position of the edge of the first substrate 410. The second clamp 480 may comprise one or more (e.g. three or more) sensors 489 (e.g. optical sensors) configured to determine a position of the edge of the second substrate 420.

Additionally or alternatively, the clamp system 400 may comprise one or more (e.g. three or more) infrared sensors 490 configured to measure the alignment between the first substrate 410 and the second substrate 420. As shown in Figure 5, the one or more infrared sensor(s) are mounted on the second clamp 480. As will be appreciated, the one or more infrared sensors 490 may instead be mounted on the first clamp 470. One or more infrared sensors 490 may be mounted on the first clamp 470 and one or more infrared sensors 490 may be mounted on the second clamp 480. The infrared sensor mounted on one clamp (e.g. the first clamp 470) may be configured to measure the position of an alignment mark on the opposite substrate (e.g. the second substrate 420). The infrared sensors 490 may be able to look through the second substrate 420, and thus measure the vertical gap between the substrates 410, 420 and the extent to which the first substrate 410 is parallel to the second substrate 420 (e.g. with nm-accuracy).

Additionally or alternatively, alignment of the first substrate 410 and the second substrate 420 may comprise (i) measuring the position of the substraets 410, 420 relative to their respective clamps 470, 480; and (ii) positioning the first clamp 470 with the second clamp 480 such that the substrates 410, 420 are aligned. Step (i) may be a preliminary step, e.g. a step performed at a measurement station of the bonding tool 330 (which may be different to a bonding station of the bonding tool, i.e. a station at which the bonding occurs).

A surface of the first substrate 410 which faces the second substrate 420 may be referred to as a facing surface 411 of the first substrate 410. The facing surface 411 of the first substrate 410 may also be referred to as a bonding surface of the first substrate 410. A surface of the second substrate 420 which faces the first substrate 410 may be referred to as a facing surface 421 of the second substrate 420. The facing surface 421 of the second substrate 420 may also be referred to as a bonding surface of the second substrate 420. The facing/bonding surfaces 412, 422 of the first and second substrates 410, 420 may be as described with reference to Figures 4 and 4A-B. After decreasing the distance between the first substrate 410 and the second substrate 420 as described above, the facing surface 411 of the first substrate 410 may be substantially parallel to the facing surface 421 of the second substrate 420.

After decreasing the distance between the first substrate 410 and the second substrate 420, a distance between the facing surface 411 of the first substrate 410 and the facing surface 421 second substrate 420 may be 10 $\mu$m or less, optionally 5 $\mu$m or less, and optionally 1 $\mu$m or less. Thus, at the point in time at which bonding between first substrate 410 and the second substrate 420 is initiated, the distance between the facing surface 411 of the first substrate 410 and the facing surface 421 of the second substrate 420 may be 10 $\mu$m or less, optionally 5 $\mu$m or less, and optionally 1 $\mu$m or less. This distance may be less than the distance in known bonding methods. By making the distance between the facing surfaces 421, 422 of the substrates very small before the bonding process is initiated, the facing surfaces 411, 421 of the first and second substrates 410, 420 can be brought into contact with one another at different points simultaneously when the bonding process is initiated.

Bonding between the facing surfaces of the substrates 410, 420 may be initiated at each point where the facing surfaces come into contact with one another. Thus, bonding may be initiated at different points ("bond initiation points") distributed over the facing surfaces of the substrates 410, 420. A bond front may propagate radially outward from each bond initiation point. By the presence of multiple bond initiation points (e.g. instead of one bond initiation point, as explained with reference to Figures 4A and 4B), a plurality of smaller bond fronts are formed (e.g. instead of one large bond front). Consequently, the distortion of the substrates may be reduced. For example, the radially outward expansion (e.g. stretch) described with reference to Figures 4A and 4B may be reduced or eliminated. However, the plurality of smaller bond fronts may still give rise to some distortion in the substrates.

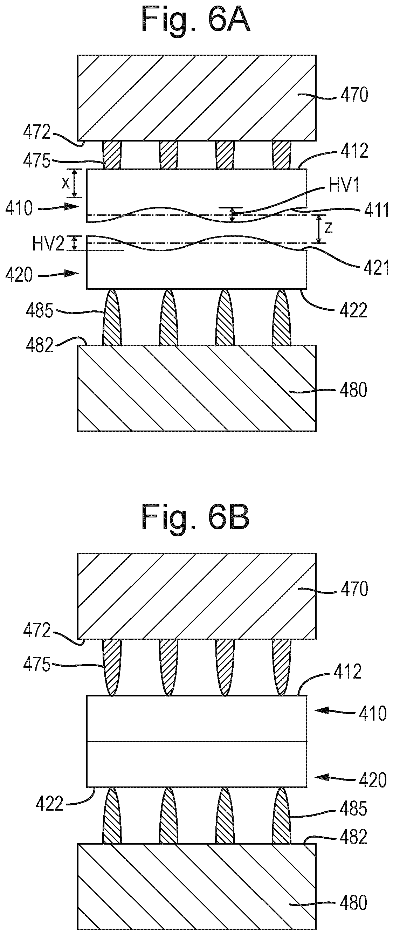

If the facing surfaces of the substrates 410, 420 are completely flat, bonding between the substrates 410, 420 may be initiated by further decreasing the distance between the facing surface 411 of the first substrate 410 and facing surface 421 of the second substrate 420 to be substantially zero. In such cases, bonding may be initiated across substantially all of the facing surfaces 411, 421 of the first and second substrates 410, 420 simultaneously. Thus, there may be substantially no bond front propagation during the bonding method. Therefore, there may be very little distortion induced in the substrates 410, 420 during the bonding method. In some cases, even where there is a very high degree of flatness in the facing surfaces of the substrate 410, 420, there may be localised peaks in the facing surfaces of the substrates 410, 420 in positions corresponding to support protrusions 475, 485 (see Figure 6A). Thus, bonding may be initiated at a plurality of different bond initiation points across the facing surfaces of the substrates 410, 420, with each bond initiation point corresponding to the position of a support protrusion 475, 485.

However, in many cases, the facing surfaces of the substrates 410, 420 are not completely flat. The facing surfaces of the substrates 410, 420 may not be completely flat because of one or more of: (i) a thickness variation in the substrates 410, 420; (ii) imperfect flatness of a support plane formed by distal ends of the support protrusions 475, 485 on which the substrates 410, 420 are supported; and (iii) features formed on the facing surfaces 411, 421 of the substrates 410, 420.

If the facing surfaces of the substrates 410, 420 are not completely flat, decreasing the distance between the facing surface 411 of the first substrate 410 and facing surface 421 of the second substrate 420 to zero would not initiate bonding across substantially all of the facing surfaces of the first and second substrates 410, 420 simultaneously. This is because some position(s) on the facing surfaces 411, 421 of the first and second substrates 410, 420 (e.g. position(s) corresponding to peak(s) on the first substrate 410 and/or peak(s) on the second substrate 420) would come into contact with each other before other position(s) on the facing surfaces 411, 421 of the first and second substrates 410, 420 (e.g. position(s) corresponding to trough(s) on the first substrate 410 and/or trough(s) on the second substrate 420). Thus, there would be one (or a small number of) bond initiation point(s) on the facing surfaces 411, 412 of the substrates 410, 420, from which bond fronts would propagate. This may lead to distortion in the substrates 410, 420, as explained above.

In the bonding methods of the present disclosure, a pressure in the region around the first substrate 410 and the second substrate 420 may be less than atmospheric pressure. For example, a pressure in the region around the first substrate 410 and the second substrate 420 may be less than 10 mbar, optionally less than 1 mbar, and optionally less than 0.1 mbar. By performing the bonding method in a reduced-pressure region, a risk of electrostatic discharge between the facing surfaces 411, 421 of the first and second substrates 410, 420 may be decreased. This may be important because the risk of electrostatic discharge between the facing surfaces 411, 421 of the first and second substrates 410, 420 may be increased by the close proximity of the facing surfaces 411, 421 of the first and second substrates 410, 420 prior to the initiation of the bonding.

Another advantage of performing the bonding method in a reduced-pressure region is that less air needs to be pushed out of the gap between the facing surfaces 411, 421 of the first and second substrates 410, 420 as the first and second substrates 410, 420 are pushed together. Consequently, the facing surfaces 411, 421 of the first and second substrates 410, 420 can be brought together more quickly. This may mean that less distortion is induced in the first substrate 410 during the bonding method, as is explained in further detail below. Moreover, by performing the bonding method in a reduced-pressure region, a risk that pockets of air become trapped between the first and second substrates 410, 420 is reduced.

A bonding method will now be described, in which the substrates 410, 420 are brought close together (e.g. such that an average distance between the facing surface of the first substrate 410 and the second substrate 420 may be 10 $\mu$m or less, optionally 5 $\mu$m or less, and optionally 1 $\mu$m or less), and then a force applied to one of the substrates (e.g. the first substrate 410) to initiate the bonding between first substrate 410 and the second substrate 420. The bonding method is depicted schematically in 6A, 6B, and 10A-11B.

Before the application of the force which initiates the bonding, the facing surfaces of the substrate 410, 420 may be completely separated from one another, e.g. having no points of contact. Contact between the facing surfaces of the substrates 410, 420 before the application of the force which initiates the bonding is preferably avoided because it could lead to initiation of the bonding between the substrates 410, 420, in which a bond front would propagate outward from the point of contact.

To ensure that the facing surfaces of the substrate 410, 420 are completely separated from one another, the average distance (marked as "z" in Figure 6A) between the facing surfaces of the first semiconductor substrate and the second semiconductor substrate may be greater than the sum of: (i) the height variation of the facing surface 411 of the first substrate 410 (marked as "HV1" in Figure 6A) divided by two, and (ii) the height variation of the facing surface 421 of the second substrate 420 (marked as "HV2" in Figure 6A) divided by two. The height variation of a surface may be a distance (in a direction perpendicular to the surface) between a tallest peak and a deepest valley.

In accordance with the bonding method of the present disclosure, the force that is applied to the first substrate 410 to initiate the bonding between the first substrate 410 and the second substrate 420 may be applied using support protrusions 475 on the first clamp 470 (e.g. at least a portion of the plurality of support protrusions on the first clamp 470). For example, the bonding may be initiated by the support protrusions 475 generating the force or by the support protrusions 475 transmitting the force. That is, the support protrusions 475 on the first clamp 470 apply the force which initiates the bonding between the first substrate 410 and the second substrate 420. The force that is applied to the first substrate 410 to initiate the bonding may be a contact force.

The overall force that is applied to the first substrate 410 may comprise (e.g. may be made up of) a plurality of force elements. Each force element may be a force applied to the first substrate 410 by one support protrusion 475. All of the force elements which make up the force that is applied to the first substrate 410 may be applied simultaneously.

Applying the force to the first substrate 410 using the support protrusions 475 on the first clamp 470 (e.g. by the support protrusions 475 generating the force or by the support protrusions 475 transmitting the force) may result in a plurality of bond initiation points. Consequently, applying the force to the first substrate 410 using the support protrusions on the first clamp 170 may initiate a plurality of bond fronts. Each support protrusion 475 which is used to apply the force to the first substrate 410 may create a bond initiation point. Thus, there may be one bond front for each support protrusion 475 which is used to apply the force to the first substrate 410. Because the forces exerted by all of the support protrusion 475 are simultaneous, the plurality of bond fronts may be initiated simultaneously.

A bonding method in which a plurality of relatively small bond fronts are initiated may result in less distortion of the first substrate 410 than a bonding method in which one (or a very small number of) large bond front(s) are initiated in the first substrate 410 (such as the bonding method depicted in Figures 4A-B).

Generally, increasing the number of support protrusions 475 on the first clamp 470 that are used to exert the force on the first substrate 410 may increase the number of bond fronts initiated, and decrease the magnitude of each of those bond fronts. Thus, increasing the number of support protrusions 475 that are used to apply the force to the first substrate 410 may reduce the distortion induced in the first substrate during the bonding method. The number of support protrusions used to apply the force may be, for example, 50 or more, 500 or more, 5,000 or more, etc. Optionally, the force that is applied to the first substrate 410 to initiate the bonding between the first substrate 410 and the second substrate 420 may be applied using substantially all of the plurality of support protrusions 475 on the first clamp 470. For example, substantially all of the plurality of support protrusions 475 on the first clamp 470 may generate the force or substantially all of the plurality of support protrusions 475 on the first clamp 470 may transmit the force.

Figures 6A and 6B schematically depict an example of the bonding method in which the support protrusions on the first clamp 470 apply the force on the first substrate as a result of elastic deformation undergone by the plurality of support protrusions 475. Figures 6A and 6B are intended only to explain the concepts discussed below, and are in no way representative of the scale and/or relative proportions of the components used in the bonding method.

As shown in Figures 6A and 6B, the first clamp 470 comprises four support protrusions 475. These four support protrusions 475 are representative of a much larger number of support protrusions 475. For example, the first clamp may comprise 50, 500, 5,000, 50,000 or more protrusions 475.

In Figure 6A, the first substrate 410 is clamped to the first clamp 470. The first clamp 470 exerts a clamping force (e.g. an electrostatic clamping force) on the first substrate 410. A clamping pressure associated with the clamping force may be, for example, is less than 1,000 mbar, optionally less than 500 mbar, optionally less than 300 mbar, and greater than 10 mbar. The first substrate 410 is supported on the support protrusions 475, which are disposed in between a back surface 412 of the first substrate 410 and a main body of the first clamp 470. Thus, the application of the clamping force on the first substrate 410 by the first clamp 470 means that the back surface 412 of the first substrate 410 exerts a force on the support protrusions 475.

The support protrusions 475 may be configured to deform (e.g. be compressed) upon the application of the force that is exerted on the support protrusions 475 by the back surface 412 of the first substrate 410. As shown in Figure 6A, the support protrusions 475 are compressed by a distance x. The compression of the support protrusions 475 may be in a direction that is substantially perpendicular to the first substrate 410. The compression of the support protrusions 475 may comprise reversible (e.g. elastic) deformation.

Before the force is applied to the first substrate 410 to initiate bonding of the first substrate 410 and the second substrate 420, the facing surfaces of the first and second substrates 410, 420 are separated from one another by an average distance, z. As is exaggerated in Figure 6A, the facing surface of the first substrate 410 has a height variation HV1 and the facing surface of the second substrate 420 has a height variation HV2. The distance z is such that the facing surfaces of the first and second substrates 410, 420 do not contact one another despite the height variations HV1, HV2. As above, the distance z may be 10 $\mu$m or less, optionally 5 $\mu$m or less, and optionally 1 $\mu$m or less. It may be preferable that the distance z is as small as possible (while ensuring that the facing surfaces of the substrates 410, 420 do not contact).

Bonding between the facing surfaces 411, 412 of the first substrate 410 and the second substrate 420 may be initiated by releasing the clamping force exerted on the first substrate 410 by the first clamp 470. As a result of releasing the clamping force, the force which caused the compression of the support protrusions 475 is released. Therefore, upon the release of the clamping force, the support protrusions 475 expand (e.g. de-compress), and exert a force on the back surface 412 of the first substrate 410 in the direction of the second substrate 420. This is the force which initiates the bonding of the first substrate 410 and the second substrate 420. The force exerted by the support protrusions 475 may be an elastic force. The elastic force may be a force induced by the compression of the support protrusions 475. The support protrusions 475 may be considered to act as springs. In this way, the support protrusions 475 generate the force which initiates the bonding between the first and second substrates 410, 420.

A force element exerted on the back surface 412 of the first substrate 410 by a support protrusion 475 may cause a portion of the first substrate 410 corresponding to that support protrusion 475 to be accelerated towards the second substrate 420. This causes said portion of the first substrate 410 to come into contact with the facing surface of the second substrate 420, resulting in a bond initiation point. As this happens for each support protrusion 4775 on the first clamp 470, a plurality of bond initiation points are created (e.g. one bond initiation point for each support protrusion 475). These bond initiation points are distributed over the first substrate 410. As above, a bond front may be initiated-and propagate radially outward from-each bond initiation point.

Figure 6B depicts the bonding method after the first substrate 410 and the second substrate 420 have been fully bonded together. At this stage, the support protrusions 475 are fully extended (e.g. fully de-compressed). The distance z between the facing surfaces of the first substrate 410 and the second substrate 420 may be approximately the same as the distance x by which the support protrusions are compressed upon the application of the clamping force to the first substrate 410. This may be such that the expansion of the support protrusions 475 upon the release of the clamping force pushes the first substrate 410 such that all of the facing surface 411 of the first substrate 410 comes into contact with the facing surface 421 of the second substrate 420. In other words, by x = z, the gap between the facing surfaces 411, 421 of the substrates 410, 420 is fully closed.

To initiate the bonding between the first substrate 410 and the second substrate 420 using the elastic extension of the support protrusions 475, it may be advantageous for the first clamp to release the clamping force quickly. This may be such that a residual clamping force exerted on the first substrate 410 by the first clamp 470 does not impede the acceleration of the first substrate 410 towards the second substrate 420. In some examples, during the release of the clamping force, a time taken for the clamping force to decrease from an initial clamping force to less than 10% of the initial clamping force may be less than 25 ms, optionally less than 5 ms, further optionally less than 2 ms.

In some examples, the release of the clamping force may comprise a reduction of the clamping force where the reduced value of the clamping force is non-negligible. That is, the release of the clamping force may comprise a reduction of the clamping force from an initial clamping force to a reduced clamping force, and the time taken for the clamping force to decrease from the initial clamping force to the reduced clamping force may be less than 25 ms, optionally less than 5 ms, further optionally less than 2 ms. The reduced clamping force may be, for example, between 10% and 90% of the initial clamping force. As described below, it is the reduction of the clamping force which results in the expansion of the support protrusions 475, causing the initiation of the contact between the facing surfaces of the first substrate 410 and the second substrate 420.

In some embodiments, the clamping force may not be fully released so as to prevent slipping between the distal ends of the support protrusions 475 and the back surface 412 of the first substrate 410. The initiation of the bonding may be initiated by an abrupt reduction in the clamping pressure, e.g. from an initial value to a reduced value. The initial value may be, for example, 500 mbar, and the reduced value may be, for example, 200 mbar. A time taken for the clamping force to decrease from the initial clamping force to the reduced clamping force may be less than 25 ms, optionally less than 5 ms, further optionally less than 2 ms

Where the first clamp 470 is an electrostatic clamp, the rate at which the clamping force is released may be dependent on a rate of discharge of clamp electrodes within the first clamp 470. The rate of discharge of the clamp electrodes may be dependent on the time constant (i.e. the RC constant) of the discharging circuit. Thus, the rate of discharge of the clamp electrodes may be increased by decreasing the resistance within the discharging circuit and/or decreasing a capacitance associated with the clamp electrodes. The rate of discharge may also be increased by reversing a polarity of the potential over the clamp electrodes. Additionally or alternatively, the rate at which the clamping force is released may be increased by increasing the number of clamp electrodes, such that each clamp electrode accumulates a smaller amount of charge when used to exert the clamping force on the first substrate 410.

In particularly advantageous embodiments, uncontrolled bond front propagation is minimised by configuring the initiation of the bonding between the first substrate 410 and the second substrate 420 such that a bond front initiated at the site of one support protrusion 475 is not able to propagate to reach the site of a neighbouring burl. That is, a bond front initiated at the site of any support protrusion is only able to propagate over a distance that is less than the pitch of the support protrusions. In such cases, one bond front will be initiated for each support protrusion 475. Minimising uncontrolled bond front propagation reduces the distortion induced in the substrate, because the distortion induced in the substrate by a bond front is proportional to the distance over which the bond front propagates.

Preferably, a bond front initiated at the site of any support protrusion 475 is not able to propagate to the extent that it gets close to neighbouring support protrusions 475. For example, a bond front initiated at the site of any support protrusion may only able to propagate over a distance that is less than half the pitch of the support protrusions 475. This may ensure that bond front propagation around the sites of support protrusions is not disturbed by interference of different bond fronts. thus, distortion of the first substrate 410 can be minimised.

To achieve the above-described minimisation of uncontrolled bond front propagation, the system may be configured as follows. For a bond front initiated at the site of any support protrusion to propagate over a distance that is less than the pitch of the support protrusions, the time taken for a bond front to propagate over the distance between adjacent support protrusions (i.e. the support protrusion pitch) may be greater than the time taken for the gap between the facing surfaces 411, 421 of the substrates 410, 420 (i.e. distance z) to be fully closed. For a bond front initiated at the site of any support protrusion to propagate over a distance that is less than half the pitch of the support protrusions. The time taken for a bond front to propagate over half the distance between adjacent support protrusions (i.e. half the support protrusion pitch) may be greater than the time taken for the gap between the facing surfaces 411, 421 of the substrates 410, 420 (i.e. distance z) to be fully closed.

As above, the speed of the propagation of the bond front through the first substrate 410 may depend on factors such as: patterns in the first substrate 410; crystal orientations in the first substrate 410; and pre-existing tensions in the first substrate 410. The speed of the propagation of the bond front through the first substrate 410 may also depend on the ambient pressure in the environment in which the bonding method takes place: the speed of propagation may increase as the ambient pressure decreases. For example, when the ambient pressure in the environment is of the order of 10 mbar, the speed of propagation may be in the order of 100 mm/s, and when the pressure in the environment is in the order of 0.1 mbar, the speed of propagation may be in the order of 1,000 mm/s.

Next, preferred parameters, dimensions and settings for the bonding method depicted in Figures 6A and 6B will be described. Some of the preferred parameters, dimensions and settings may be to increase a likelihood that the time taken for a bond front to propagate over the distance between adjacent support protrusions 475 is greater than the time taken for the gap between the facing surfaces 411, 421 of the substrates 410, 420 (i.e. distance z) to be fully closed.

Generally, it may be preferable that the speed with which the first and second substrates 410, 420 are brought together is large enough for the propagation distance of bond fronts to be limited (e.g. to less than the pitch of the support protrusions). However, it may also be preferable for the speed with which the first and second substrates 410, 420 are brought together not to be excessively large. Thus, it may be preferable for the speed with which the first and second substrates 410, 420 are brought together to be the minimum speed required to limit bond front propagation distance (e.g. to less than the pitch of the support protrusions).

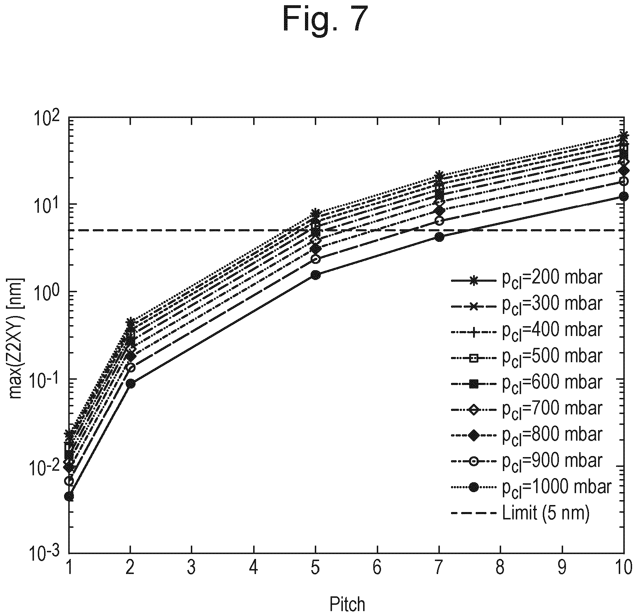

Figure 7 depicts several of plots maximum lateral displacement in the first substrate 410 ("max(Z2XY) [nm]") against the pitch of support protrusions 475 on the first clamp 470. The lateral displacement in the first substrate 410 may be caused by the clamping pressure applied to the first substrate 410 while the first substrate 410 is clamped to the first clamp 470. Each of the plots is for a different clamping pressure, ranging from 200 mbar to 1,000 mbar. The data for the plots was obtained via a simulation, where the support protrusions 475 were assumed to be spring members with a stiffness of 5 MN/m.

It may be advantageous for the maximum lateral displacement in the first substrate 410 not to exceed 10 nm, and preferably not to exceed 5 nm. A maximum lateral displacement of 5 nm is shown in Figure 7 as a dashed line.

As shown in Figure 7, increasing the clamping pressure results in an increase in the maximum lateral displacement in the first substrate 410. Further, increasing the pitch of the support protrusions 475 increases the maximum lateral displacement in the first substrate 410. Thus, by reducing the clamping pressure and/or reducing the pitch, a maximum lateral displacement in the first substrate 410 that is less than 5 nm can be achieved. A maximum lateral displacement in the first substrate 410 of less than 5 nm can be achieved for all clamping pressures where the pitch of the support protrusions 475 is less than approximately 4.5 mm. A maximum lateral displacement in the first substrate 410 of less than 5 nm can be achieved where the pitch of the support protrusions 475 is less than approximately 7 mm for lower clamping pressures (e.g. 200 mbar).

It should be recognised that, even where the maximum lateral displacement exceeds 5 nm, the maximum lateral displacement is still much improved over prior art configurations. Consequently, in general, a pitch of the plurality of support protrusions 475 may be less than 10 mm, less than 7 mm, and optionally less than 4.5 mm.

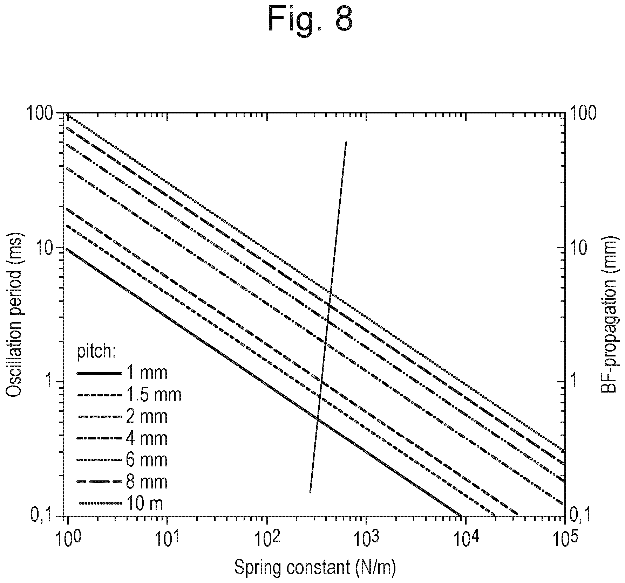

Figure 8 depicts a plot of the oscillation period of a support protrusion 475 against the spring constant of the support protrusion 475. As the support protrusion 475 is considered to act as a spring, a time period, T, for the oscillation of the support protrusion 475 is given by *Equation 1.*

$$T = 2\pi \sqrt{\frac{m_W}{k_{SP}}}$$

*Equation 1*

In *Equation* 1, $m_W$ is the effective mass that is supported by a single support protrusion 475, which may be equal to the total mass of the first substrate 410 divided by the total number of support protrusions 475 on which the first substrate 410 is supported. $k_{SP}$ is the spring constant of the support protrusion. Figure 8 depicts several plots for different pitches of the support protrusions 475. The pitch of the support protrusions 475 influences the time period of the oscillation T, because the pitch of the support protrusions 475 determines the effective mass that is supported by a single support protrusion 475.

As above, to ensure the initiation of one bond front per support protrusion 475, the time taken for the bond front to propagate over the distance between adjacent support protrusions 475 may be greater than the time taken for the gap between the facing surfaces 411, 421 of the substrates 410, 420 (i.e. distance z) to be fully closed. For the time taken for the bond front to propagate over the distance between adjacent support protrusions 475 to be greater than the time taken for the gap between the facing surfaces 411, 421 of the substrates 410, 420 to be fully closed, the time taken for the bond front to propagate over the distance between adjacent support protrusions 475 may be greater than half of the time period, T, for the oscillation of the support protrusions 475. Thus, in general it may be preferable for $\pi \sqrt{\frac{m_W}{k_{SP}}} < \frac{p}{v}$, where v is the speed of the propagation of the bond front and $p$ is the pitch of the support protrusions 475. For the time taken for the bond front to propagate over *half* the distance between adjacent support protrusions 475 to be greater than the time taken for the gap between the facing surfaces 411, 421 of the substrates 410, 420 to be fully closed, it may be preferable for $2\pi\sqrt{\frac{m_W}{k_{SP}}} < \frac{p}{v}$.

On Figure 8, the near-vertical line in Figure 8 (i.e. the line which is not parallel to the other plots) is a demarcation line demarcating the point at which the time taken for the bond front to propagate over half the distance between adjacent support protrusions 475 is greater than half the time period, T, for the oscillation of the support protrusion 475. In other words, the demarcation line is where the bond front propagation distance is equal to half the pitch of the support protrusions 475.

As shown in Figure 8, the time taken for the bond front to propagate over half the distance between adjacent support protrusions 475 may be greater than the time period T for the oscillation of the support protrusion 475 where the spring constant $k_{SP}$ of the support protrusions 475 is greater than approximately 300 N/m. This is the case where the pitch of the support protrusions is between 1 mm and 10 mm (and would likely be the case for pitches outside of this range due to the slope of the demarcation line). Thus, one bond front is initiated per support protrusion occurs where the spring constant $k_{SP}$ of the support protrusions 475 is greater than approximately 300 N/m.

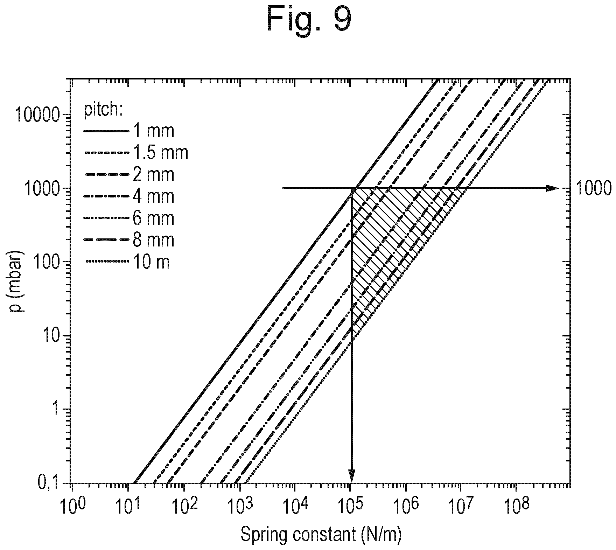

Figure 9 depicts plots of a required clamping pressure reduction $P_r$ against the spring constant of the support protrusion 475. The required clamping pressure reduction may be the clamping pressure required to cause expansion of the support protrusion 475 by the distance x. As above, the distance *x* may be the same as the separation between the facing surfaces 411, 421 of the substrates 410, 420 prior to the initiation of bonding, *z*. This may be such that the extension of the support protrusions 475 fully closes the gap between the facing surfaces of the substrates 410, 420. Thus, the required clamping pressure reduction may be the clamping pressure reduction required to cause expansion of the support protrusion 475 by the distance *z*. The required clamping pressure reduction $P_r$ is given by Hooke's law, as shown in *Equation 2*, where *A* is the effective area of the back surface 412 of the first substrate supported by one support protrusion 475 (which may be equal to the total area of the back surface of 412 the first substrate 410 divided by the total number of support protrusions 475.

$$P_r = \frac{k_{SP}z}{A}$$

*Equation 2*

For the plots depicted in Figure 9, it was assumed that the distance *z* was 1 µm. Each plot in Figure 9 is for a different pitch of the support protrusions. The pitch of the support protrusions 475 affects the required clamping pressure reduction $P_r$ because the pitch of the support protrusions 475 determines the effective area of the back surface 412 of the first substrate 410 that is supported by each support protrusion 475.

In general, and based on *Equation 2*, it may be preferable for the clamping pressure reduction to be equal to or greater than $\frac{k_{SP}z}{A}$ .

It may be uncommon for the clamping pressure to exceed 1,000 mbar in semiconductor manufacturing applications because of the risk of material damage and/or electrostatic discharge. When the clamping pressure is 1,000 mbar or less, it may be preferable for the spring constant of the support protrusions 475 of the first clamp 470 to be greater than or equal to $10^5$ N/m. In some cases, it may be difficult for the spring constant of the support protrusions 475 to be less than $10^7$ N/m due to material and/or manufacturing considerations.

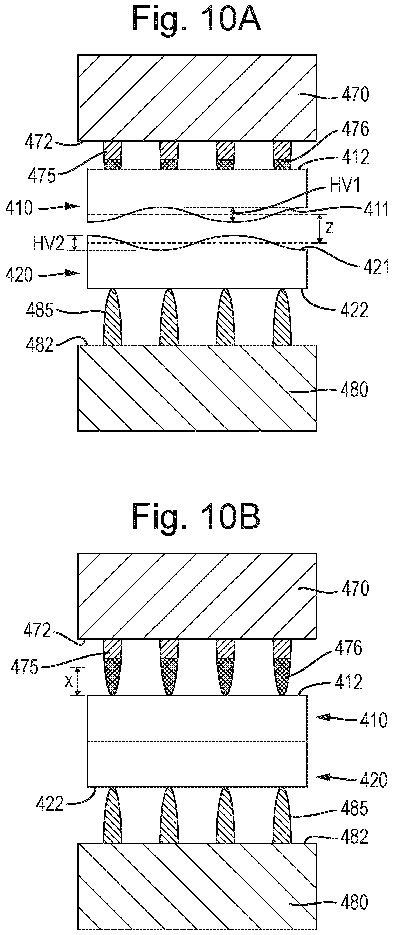

Figures 10A to 11B schematically depict examples of the bonding method in which support protrusions 475 on the first clamp 470 (e.g. at least a portion of the support protrusions 475 on the first clamp, optionally substantially all of the support protrusions 475 on the first clamp 470) are actuated to apply the force on the first substrate 420. The actuation of the support protrusions may generate the force which initiates the bonding between the substrates 410, 420. Various aspects of the bonding method depicted in Figures 6A and may apply equally to the bonding method depicted in Figures 10A to 11B.

For the actuation of the support protrusions 475, the first clamp 470 comprises one or more actuators. The one or more actuators may be, for example, piezoelectric actuators. The one or more piezoelectric actuators may comprise at least one piezoelectric element. The one or more piezoelectric actuators may comprise a plurality of piezoelectric elements arranged in a stack. The range of the one or more piezoelectric actuators may be determine by a height of the piezoelectric stack. As will be appreciated, other types of actuators may also be used.

In the bonding methods depicted in Figures 10A to 11B, the clamping force exerted on the first substrate 410 by the first clamp 470 may be released at the same time as the one or more support protrusions 475 are actuated. This may allow the first substrate 410 to be accelerated towards the second substrate 420 as required. As with the bonding method depicted in Figures 6A and 6B, it may be advantageous for the first clamp 470 to release the clamping force quickly. This may be so that a residual clamping force exerted on the first substrate 410 by the first clamp 470 does not impede the acceleration of the first substrate 410 towards the second substrate as a result of the force exerted on the first substrate 410 by the support protrusions 475. In some examples, during the release of the clamping force, a time taken for the clamping force to decrease from an initial clamping force to less than 10% of the initial clamping force may be less than 10 ms, optionally less than 5 ms, further optionally less than 2 ms.

In some embodiments, the clamping force may not be fully released so as to prevent slipping between the distal ends of the support protrusions 475 and the back surface 412 of the first substrate 410. The initiation of the bonding may be initiated by an abrupt reduction in the clamping pressure, e.g. from an initial value to a reduced value. The initial value may be, for example, 500 mbar, and the reduced value may be, for example, 200 mbar.

In the bonding method depicted in Figures 10A and 10B, each of the support protrusions 475 which is used to apply the force to the first substrate 420 comprises an actuator 476 (e.g. a piezoelectric actuator). Thus, if substantially all of the support protrusions 475 on the first clamp 410 are used to apply the force which initiates the bonding between the first substrate 410 and the second substrate 420, substantially all of the support protrusions on the first clamp 410 may comprise an (e.g. their own) actuator.

As shown in Figures 10A and 10B, the actuators 476 may be located at the distal ends of the support protrusions 475. However, as will be appreciated, the actuators 476 may, additionally or alternatively, be located at a proximal end (i.e. at the base) of the support protrusions 475. In some examples, each support protrusion 475 may be formed entirely of an actuator, i.e. the actuator may extend from the proximal end of the support protrusion 475 to the distal end of the support protrusion 475.

Figure 10A depicts a time before the actuation of the actuators 476. Figure 10B depicts a time after the actuation of the actuators. In the bonding method depicted in Figures 10A and 10B, when the actuators 476 are actuated, the actuators extend in the vertically downward direction, applying a force on the back surface 412 of the first substrate 410 in the direction of the second substrate 420. The distance by which the actuators extend, x, may be sufficient to bring substantially all of the facing surface 411 of the first substrate 410 into contact with the facing surface 421 of the second substrate 420. For example, the distance by which the actuators extend, x, may be approximately equal to the average separation between the facing surfaces 411, 421 of the substrates 410, 420 before the initiation of bonding therebetween, i.e. distance z.

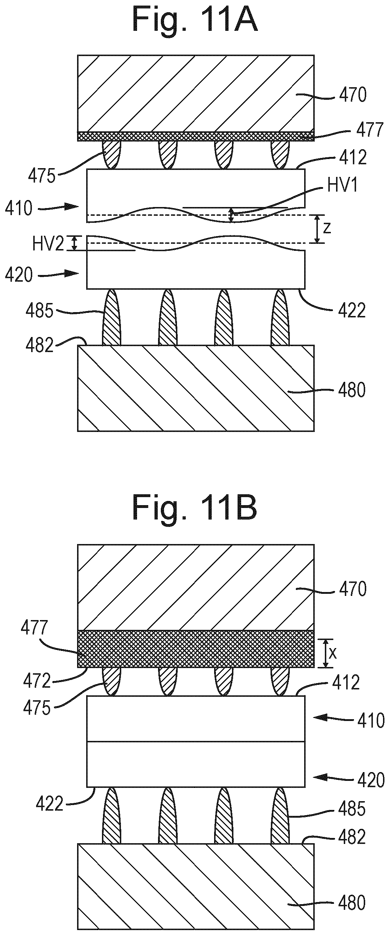

In the bonding method schematically depicted in Figures 11A and 11B, the first clamp 470 comprise an actuator layer 477 (e.g. a piezoelectric layer) disposed between a main body of the first clamp 470 and the support protrusions 475. The actuator layer 477 may be configured to actuate a plurality of the support protrusions 475. For example, the actuator layer 477 may be configured to actuate substantially all of the support protrusions 475 on the first clamp 470 that are used for the application of the force to the first substrate 470 that initiates the bonding between the first substrate 410 and the second substrate 420. Thus, if substantially all of the support protrusions 475 on the first clamp 410 are used to apply the force which initiates the bonding between the first substrate 410 and the second substrate 420, the actuator layer 477 may be configured to actuate substantially all of the support protrusions 475 on the first clamp 470.

Figure 11A depicts a time before the actuation of the actuator layer 477. Figure 11B depicts a time after actuation of the actuator layer 477. In the bonding method depicted in Figures 11A and 11B, when the actuator layer 477 is actuated, the actuator layer 477 extends in the vertically downward direction, applying a force on the support protrusions 475 in the direction of the second substrate 420. In turn, the support protrusions 475 apply a force on the back surface 412 of the first substrate 410 in the direction of the second substrate 420.

The distance by which the actuator layer 477 extends, x, may be sufficient to bring substantially all of the facing surface 411 of the first substrate 410 into contact with the facing surface 421 of the second substrate 420. For example, distance by which the actuator layer 477 extends, x, may be approximately equal to the average separation between the facing surfaces 411, 421 of the substrates 410, 420 before the initiation of bonding therebetween, i.e. the distance z.

In some embodiments (not shown) the first clamp 470 itself may be actuated (e.g. caused to move) in order to initiate the bonding between the first and second substrates 410, 420. This may be instead of, or in addition to, actuation of the support protrusions 475 and/or the generation of an elastic force by the support protrusions 475. In such embodiments, the plurality of support protrusions 475 may transmit the force to the first substrate 410 (the force being generated by the clamp 470, or the actuation means which is configured to actuate the clamp 470).

In the above description, a bonding method has been described in which the support protrusions 475 of the first clamp 470 are configured to apply a force to the first substrate 410 to initiate the bonding between the first substrate 410 and the second substrate 420. Throughout the bonding method, the second substrate 420 may be clamped to the second clamp 480 (e.g. by electrostatic clamping forces), and remain stationary.

As will be appreciated, in a bonding method in accordance with the present disclosure, the support protrusions 485 of the second clamp 480 may be configured to apply a force to the second substrate 420 to initiate the bonding between the first substrate 410 and the second substrate 420. This may be instead of the support protrusions 475 of the first clamp 470 being configured to apply a force to the first substrate 410 to initiate the bonding. The force applied to the second substrate 420 by the support protrusions 485 of the second clamp 480 may be in the direction of the first substrate 410.

In some embodiments, the support protrusions 475 of the first clamp 470 are configured to apply a force to the first substrate 410 and the support protrusions 485 of the second clamp 480 are also configured to apply a force to the second substrate 420. This may be such that the bonding between the first substrate 410 and the second substrate 420 is initiated by the force applied to the first substrate 410 by the support protrusions 475 of the first clamp 470 and the force applied to the second substrate 420 by the support protrusions 485 of the second clamp 480. The force applied to the first substrate 410 by the support protrusions 475 of the first clamp 470 may be applied at the same time as the force applied to the second substrate 420 by the support protrusions 485 of the second clamp 480. That is, the applying of the force to the first substrate 410 using the support protrusions 475 on the first clamp 470 and the applying of the force to the second substrate 420 using the support protrusions 485 on the second clamp 480 may be performed simultaneously.

Further embodiments of the invention are disclosed in the following list of numbered clauses:

1. A method of bonding a first semiconductor substrate and a second semiconductor substrate, the method comprising:

clamping the first semiconductor substrate to a clamp such that the first semiconductor substrate is supported by a plurality of support protrusions on the clamp; and
applying a force to the first semiconductor substrate to initiate the bonding of the first semiconductor substrate and the second semiconductor substrate, wherein the force is generated by, or transmitted by, the plurality of support protrusions on the clamp, and
wherein the applying of the force to the first semiconductor substrate to initiate the bonding of the first semiconductor substrate and the second semiconductor substrate simultaneously initiates a plurality of bond fronts.

2. The method of clause 1, wherein a bond front is initiated by each of the plurality of support protrusions which are used to apply the force to the first semiconductor substrate.
3. The method of any of the preceding clauses , wherein the force is generated by, or transmitted by, substantially all of the plurality of support protrusions on the clamp.
4. The method of any of the preceding clauses, wherein the force applied to the first semiconductor substrate comprises a plurality of force elements, wherein each force element is applied to the first semiconductor substrate by a support protrusion of the plurality of support protrusions.
5. The method of any of the preceding clauses, wherein a pitch of the plurality of support protrusions is less than 10 mm, less than 7 mm, and optionally less than 4 mm.
6. The method of any of the preceding clauses, wherein a clamping pressure exerted on the first semiconductor substrate during the clamping of the first semiconductor substrate to the clamp is less than 1,000 mbar, optionally less than 500 mbar, optionally less than 300 mbar, and greater than 10 mbar.
7. The method of any of the preceding clauses, wherein, before applying the force to the first semiconductor substrate, the first semiconductor substrate faces the second semiconductor substrate.
8. The method of any of the preceding clauses, further comprising, before applying the force to the first semiconductor substrate, decreasing a distance between the first semiconductor substrate and the second semiconductor substrate, optionally wherein the distance between the first semiconductor substrate and the second semiconductor substrate is decreased such that an average distance between facing surfaces of the first semiconductor substrate and the second semiconductor substrate is 10 $\mu$m or less, optionally 5 $\mu$m or less, and optionally 1 $\mu$m or less.
9. The method of clause 8, wherein, after the decreasing of the distance between the first semiconductor substrate and the second semiconductor substrate, the first semiconductor substrate and the second semiconductor substrate are parallel to one another and/or the first semiconductor substrate and the second semiconductor substrate are aligned with respect to one another.
10. The method of clause 8 or 9, wherein the average distance between the facing surfaces of the first semiconductor substrate and the second semiconductor substrate is greater than the sum of: (i) the height variation of the facing surface of the first semiconductor substrate divided by two, and (ii) the height variation of the facing surface of the second semiconductor substrate divided by two.
11. The method of any of clauses 8 to 10, wherein the facing surfaces of the first semiconductor substrate and the second semiconductor substrate are spaced apart from one another before the initiation of the bonding between the first semiconductor substrate and the second semiconductor substrate.
12. The method of any of the preceding clauses, wherein the clamp is an electrostatic clamp.
13. The method of any of the preceding clauses, wherein the clamping of the first semiconductor substrate to the clamp comprises compression of the plurality of support protrusions.
14. The method of clause 13, wherein the applying the force to the first semiconductor substrate comprises expansion of the plurality of support protrusions.

15. The method of clause 14, wherein the expansion of the plurality of support protrusions occurs as a result of an elastic force in the plurality of support protrusions, wherein the elastic force in the plurality of support protrusions is induced by compression of the plurality of support protrusions during the clamping of the first semiconductor substrate to the clamp.

16. The method of clause 14 or 15, wherein the expansion of the plurality of support protrusions is initiated by releasing a clamping force on the first semiconductor substrate.

17. The method of clause 16, wherein during the release of the clamping force, a time taken for the clamping force to decrease from an initial clamping force to less than 10% of the initial clamping force is less than 10 ms, optionally less than 5 ms, further optionally less than 2 ms.

18. The method of any of clauses 13 to 17, wherein a spring constant, in a direction substantially perpendicular to the first semiconductor substrate when clamped to the clamp, of each of the plurality of support protrusions greater than $10^5$ N/m, and optionally less than $10^8$ N/m.

19. The method of any of clauses 1 to 13, wherein the applying the force to the first semiconductor substrate comprises actuating the plurality of support protrusions.

20. The method of clause 19, wherein the applying the force to the first semiconductor substrate comprises actuating one or more piezoelectric actuators, optionally wherein the actuating of the one or more piezoelectric actuators causes the force to be applied to the first semiconductor substrate by the plurality of support protrusions.

21. The method of clause 20, wherein the applying of the force to the first semiconductor substrate comprises actuating a piezoelectric layer disposed between a main body of the clamp and the plurality of support protrusions.

22. The method of any of the preceding clauses, wherein:

the clamp to which the first semiconductor substrate is clamped is a first clamp; and
the method further comprises clamping the second semiconductor substrate to a second clamp, wherein, when the second semiconductor substrate is clamped to the second clamp, the second semiconductor substrate is supported by a plurality of support protrusions on the second clamp.

23. The method of clause 22, further comprising, applying a force to the second semiconductor substrate to initiate the bonding of the first semiconductor substrate and the second semiconductor substrate, wherein the force applied to the second semiconductor substrate is generated by, or transmitted by, the plurality of support protrusions on the second clamp.

24. The method of clause 23, wherein the applying the force to the first semiconductor substrate and the applying the force to the second semiconductor substrate are performed simultaneously.

25. The method of any of the preceding clauses, wherein the method is performed in an environment with a pressure that is less than 10 mbar, optionally less than 1 mbar, and optionally less than 0.1 mbar.

26. The method of any of any of the preceding clauses, wherein:

the first semiconductor substrate and/or the second semiconductor substrate is/are a semiconductor wafer, optionally wherein the semiconductor wafer has a diameter of approximately 300 mm; or
the first semiconductor substrate and/or the second semiconductor substrate is/are a die.

27. A clamping system configured to perform the method of any of the preceding clauses.

28. A clamp,

wherein the clamp is configured to clamp a first semiconductor substrate in a method of bonding the first semiconductor substrate to a second semiconductor substrate;
wherein the clamp comprises a plurality of support protrusions, wherein the plurality of support protrusions are configured to support the first semiconductor substrate when the first semiconductor substrate is clamped to the clamp; and
wherein the plurality of support protrusions are configured to generate or transmit a force to the first semiconductor substrate to initiate the bonding of the first semiconductor substrate and the second semiconductor substrate, wherein the force initiates a plurality bond fronts.

29. A clamping system for bonding a first semiconductor substrate and a second semiconductor substrate, the clamping system comprising:

a first clamp, wherein the first clamp is the clamp of clause 28; and
a second clamp configured to clamp the second semiconductor substrate.

# EP 4 787 431 A1

30. A computer program comprising instructions to cause the clamping system of clause 27 or 29 to execute the steps of the method of any of clauses 1 to 26.

31. An assembly comprising the first semiconductor substrate and the second semiconductor substrate, wherein the first semiconductor substrate and the second semiconductor substrate are bonded to one another using the method of clause any of clauses 1 to 26.

32. An electronic device comprising the assembly of clause 31.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. The methods of the invention may be carried out on a computer system located in the same system as the first clamp and second clamp, or may be remote from the first clamp and second clamp. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of bonding a first semiconductor substrate and a second semiconductor substrate, the method comprising:

   clamping the first semiconductor substrate to a clamp such that the first semiconductor substrate is supported by a plurality of support protrusions on the clamp; and
   applying a force to the first semiconductor substrate to initiate the bonding of the first semiconductor substrate and the second semiconductor substrate, wherein the force is generated by, or transmitted by, the plurality of support protrusions on the clamp, and
   wherein the applying of the force to the first semiconductor substrate to initiate the bonding of the first semiconductor substrate and the second semiconductor substrate simultaneously initiates a plurality of bond fronts.

2. The method of claim 1, wherein a bond front is initiated by each of the plurality of support protrusions which are used to apply the force to the first semiconductor substrate.

3. The method of claim 1 , wherein the force is generated by, or transmitted by, substantially all of the plurality of support protrusions on the clamp.

4. The method of claim 1, wherein the force applied to the first semiconductor substrate comprises a plurality of force elements, wherein each force element is applied to the first semiconductor substrate by a support protrusion of the plurality of support protrusions.

5. The method of claim 1, further comprising, before applying the force to the first semiconductor substrate, decreasing a distance between the first semiconductor substrate and the second semiconductor substrate, optionally wherein the distance between the first semiconductor substrate and the second semiconductor substrate is decreased such that an average distance between facing surfaces of the first semiconductor substrate and the second semiconductor substrate is 10 μm or less, optionally 5 μm or less, and optionally 1 μm or less.

6. The method of claim 5, wherein, after the decreasing of the distance between the first semiconductor substrate and the second semiconductor substrate, the first semiconductor substrate and the second semiconductor substrate are parallel to one another and/or the first semiconductor substrate and the second semiconductor substrate are aligned with respect to one another.

7. The method of claim 5, wherein the average distance between the facing surfaces of the first semiconductor substrate and the second semiconductor substrate is greater than the sum of: (i) the height variation of the facing surface of the first semiconductor substrate divided by two, and (ii) the height variation of the facing surface of the second semiconductor substrate divided by two.

8. The method of claim 1, wherein the clamping of the first semiconductor substrate to the clamp comprises compression of the plurality of support protrusions.

9. The method of claim 8, wherein the applying the force to the first semiconductor substrate comprises expansion of the plurality of support protrusions.

10. The method of claim 9, wherein the expansion of the plurality of support protrusions occurs as a result of an elastic force in the plurality of support protrusions, wherein the elastic force in the plurality of support protrusions is induced by compression of the plurality of support protrusions during the clamping of the first semiconductor substrate to the clamp.

11. The method of claim 10, wherein the expansion of the plurality of support protrusions is initiated by releasing a clamping force on the first semiconductor substrate.

12. The method of claim 1, wherein the applying the force to the first semiconductor substrate comprises actuating the plurality of support protrusions.

13. The method of claim 12, wherein the applying the force to the first semiconductor substrate comprises actuating one or more piezoelectric actuators, optionally wherein the actuating of the one or more piezoelectric actuators causes the force to be applied to the first semiconductor substrate by the plurality of support protrusions.

14. A clamp,

wherein the clamp is configured to clamp a first semiconductor substrate in a method of bonding the first semiconductor substrate to a second semiconductor substrate;
wherein the clamp comprises a plurality of support protrusions, wherein the plurality of support protrusions are configured to support the first semiconductor substrate when the first semiconductor substrate is clamped to the clamp; and
wherein the plurality of support protrusions are configured to generate or transmit a force to the first semiconductor substrate to initiate the bonding of the first semiconductor substrate and the second semiconductor substrate, wherein the force initiates a plurality bond fronts.

15. A system for bonding a first semiconductor substrate and a second semiconductor substrate, the system comprising:

a first clamp, wherein the first clamp is the clamp of claim 14; and
a second clamp configured to clamp the second semiconductor substrate.

# Fig. 1

# Fig. 2

# Fig. 3

# Fig. 4A

**(i)**

**(ii)**

**(iii)**

**(iii)**

# Fig. 4B

**(i)**

**(iv)**

# Fig. 5

# Fig. 6A

# Fig. 6B

# Fig. 7

# Fig. 8

# Fig. 9

# Fig. 10A

# Fig. 10B

# Fig. 11A

470
477
475
412
HV1
410
z
HV2
420
422
485
482
480

# Fig. 11B

470
477
472
475
x
412
410
420
422
485
482
480

Europäisches
Patentamt

European
Patent Office

Office européen
des brevets

## EUROPEAN SEARCH REPORT

**Application Number**

EP 25 15 5596

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2025/029866 A1 (HICKMAN CRAIG A [US]) 23 January 2025 (2025-01-23) * paragraphs [0016] - [0040]; figures 1-3 * ----- | 1,2,4-7, 12-15 | INV. H01L21/67 H01L21/687 H01L21/683 |
| X | KR 100 857 763 B1 (EPIPLUS CO LTD [KR]) 10 September 2008 (2008-09-10) * the whole document * ----- | 1-3,5,6, 8-11,14, 15 | |
| X | US 2019/189593 A1 (KIM JUN-HYUNG [KR] ET AL) 20 June 2019 (2019-06-20) * paragraphs [0022] - [0132]; figures 1-5C * ----- | 1,2,4,5, 12,14,15 | |
| X | WO 2012/114825 A1 (TOKYO ELECTRON LTD [JP]; HIROSE KEIZO [JP]; KITAHARA SHIGENORI [JP]) 30 August 2012 (2012-08-30) * abstract; figure 22 * ----- | 1-12,14, 15 | |

**TECHNICAL FIELDS SEARCHED (IPC)**

H01L

The present search report has been drawn up for all claims

| Place of search | Date of completion of the search | Examiner |
|---|---|---|
| The Hague | 10 June 2025 | Oberle, Thierry |

# EP 4 787 431 A1

## ANNEX TO THE EUROPEAN SEARCH REPORT
## ON EUROPEAN PATENT APPLICATION NO.

EP 25 15 5596

This annex lists the patent family members relating to the patent documents cited in the above-mentioned European search report.
The members are as contained in the European Patent Office EDP file on
The European Patent Office is in no way liable for these particulars which are merely given for the purpose of information.

10-06-2025

| Patent document cited in search report | Publication date | Patent family member(s) | | Publication date |
|---|---|---|---|---|
| US 2025029866 A1 | 23-01-2025 | CN | 119340267 A | 21-01-2025 |
| | | US | 2025029866 A1 | 23-01-2025 |
| KR 100857763 B1 | 10-09-2008 | NONE | | |
| US 2019189593 A1 | 20-06-2019 | CN | 109935524 A | 25-06-2019 |
| | | KR | 20190073197 A | 26-06-2019 |
| | | US | 2019189593 A1 | 20-06-2019 |
| WO 2012114825 A1 | 30-08-2012 | JP | 5411177 B2 | 12-02-2014 |
| | | JP | 2012175041 A | 10-09-2012 |
| | | TW | 201248764 A | 01-12-2012 |
| | | WO | 2012114825 A1 | 30-08-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Handbook of Wafer Bonding. Wiley-VCH, 11 January 2012